# EUROPEAN PATENT APPLICATION

(11) **EP 3 419 140 A1**
(43) Date of publication of application: **26.12.2018**
(21) Application number: 18178868.8
(22) Date of filing: 20.06.2018
(51) Int. Cl.: H02J 3/38, H01L 31/042, H02S 30/20

(54) **PORTABLE REEL-TYPE SOLAR POWER GENERATION DEVICE AND REEL-TYPE SOLAR POWER GENERATION DEVICE**

(30) Priority: 20.06.2017 CN 201710468822; 14.06.2018 WO PCT/CN2018/091263
(71) Applicant: Beijing Apollo Ding Rong Solar Technology Co., Ltd., Beijing 100176 (CN)
(72) Inventor: WANG, Yunfang, Beijing, Beijing 100176 (CN); DAI, Fengyu, Beijing, Beijing 100176 (CN); HUO, Yanyin, Beijing, Beijing 100176 (CN); CAO, Zhifeng, Beijing, Beijing 100176 (CN)
(74) Representative: D'Halleweyn, Nele Veerle Trees Gertrudis

(57) **Abstract**

A portable reel-type solar power generation device and a reel-type solar power generation device are provided. The portable reel-type solar power generation device includes a roller, a moving apparatus and a solar cell packaged assembly. The solar cell packaged assembly is configured to be wound on the roller which is arranged on the moving apparatus.

## Description

### Technical Field

This disclosure relates to, but is not limited to, the technical field of solar power generation, particularly relates to, but is not limited to, a portable reel-type solar power generation device and a reel-type solar power generation device.

### Background

Today's society is mainly dependent on traditional fossil energy sources. 74 % of the world's total energy consumption comes from mineral energy sources such as coal, oil and natural gas. The application of fossil energy source has promoted the development of society, but the resources are increasingly exhausted. The uncontrolled use of fossil energy source has caused serious environmental pollution and climate change problems. Countries all over the world deem the development of renewable energy sources and new energy sources as an important part of their future energy strategy, and solar energy is one of the important development goals.

As a result of the rapid development of solar cells, especially flexible solar cells such as thin film solar cells, there is a prospect that these problems can be solved. At present, corresponding products have emerged in the market, such as solar charging paper, solar charging pack, etc. However, such charging equipment can only meet the short-term requirement of power. The solar power generated is unstable and thus cannot meet the power supply needed by large-sized or medium-sized electrical appliances.

With the emergence of flexible solar cell panels, many portable solar charging devices have been invented, but these portable solar charging devices still have many shortcomings, such as the area of available solar cell panels is too small, or the solar charging devices are not easy to carry with. For example, a common cell pack structure includes two substrates which are hinged and connected with each other. The substrate is provided with a solar cell on which an upper cover is arranged. The cell pack can be folded around. However, the cell pack substrate is made of hard material and can only be folded simply. After being folded, the area thereof is still very large. Moreover, the thickness of the cell pack is also very thick, which makes the cell pack not easy to carry with. The cell assembly power that can be stored is not high enough.

### Summary

The following is an overview of the subject matter described in detail herein. This summary is not intended to limit the protection scope of the claims.

The disclosure provides a portable reel-type solar power generation device and a reel-type solar power generation device. By the arrangement of the details of the device, and the optimization of the packaging method, the winding method and the electrical structure, the portable reel-type solar power generation device is suitable for supplying power to appliances which have high power requirement and guarantees a long-time stable power supply.

An embodiment of this application provides a reel-type solar power generation device which includes a roller, a moving apparatus and a solar cell packaged assembly. The solar cell packaged assembly is configured to be wound on the roller which is arranged on the moving apparatus.

In an exemplary embodiment, the reel-type solar power generation device further includes a panel arranged on the roller in which an electrical system is arranged.

In an exemplary embodiment, the reel-type solar power generation device further includes a rocker arm which is configured to be connected with the roller. The rocker arm is configured to rotate the roller so as to assist the winding and storage of the solar cell packaged assembly. The rocker arm can be folded and retracted.

In an exemplary embodiment, the electrical system is arranged inside the roller. The panel is arranged at the center of a side surface of the roller and is configured to be electrically connected to the panel circuit. Input and output ports are provided on the panel.

In an exemplary embodiment, the solar cell packaged assembly includes a packaging cloth, a cable and a flexible solar cell assembly which is configured to be bonded onto the packaging cloth. The cable is configured to be electrically connected to the flexible solar cell assembly.

In an exemplary embodiment, the four sides of the packaging cloth are folded and bonded to the flexible solar cell assembly so as to enclose the flexible solar cell assembly. A fine tube accommodating hidden pocket is arranged between the packaging cloth and the flexible solar cell assembly for arranging the cable.

In an exemplary embodiment, both ends of the packaging cloth are provided with holes. One end of the packaging cloth is provided with a handle and a snap fastener and the other end of the packaging cloth is provided with an outlet. The cable extends through the outlet and is connected to the electrical system.

In an exemplary embodiment, the fine tube accommodating hidden pockets are positioned at the edges of both sides of the packaging cloth.

In an exemplary embodiment, the cables are configured to be electrically connected with the maximum power point tracking device. Two cables are led out from each flexible solar cell assembly, one of which is a positive cable and the other of which is a negative cable. Each flexible solar cell assembly is associated with one maximum power point tracking device.

In an exemplary embodiment, the diameter of the roller is not greater than 500mm.

In an exemplary embodiment, the electrical system includes a maximum power point tracking device, a DC power supply, a charging circuit, an AC power supply, a battery and a panel circuit. The maximum power point tracking device is configured to connect with the charging circuit, the AC power supply and the battery through the DC power supply. The DC power supply, the AC power supply and the charging circuit are configured to connect to the panel circuit.

In an exemplary embodiment, an inverter is connected between the DC power supply and the AC power supply or arranged on the AC power supply.

In an exemplary embodiment, the power of each maximum power point tracking device is 100-300 W;
the DC power supply converts fluctuating photovoltaic power into a stable DC power for charging the battery, driving external DC electrical appliance and supplying power to the inverter. The output voltage of the DC power supply comprises one or more of 5V, 12V, 24V and the power of the DC power supply is 200∼1000W;
the AC power supply which is connected with an inverter is used to convert a direct current from the DC power supply or the battery into an alternating current of 110V or 220V by means of the inverter, in order to supply power to external AC electrical appliance. The power of the AC power supply is 200∼1000W;
the battery is configured for storing energy, and the stored energy is 200∼1000Wh;
the charging circuit charges the battery by using an alternating current which is supplied from outside when there is no sunlight in the environment or solar power is not used for generating electricity; and
the panel circuit includes a protection circuit which protects the output power supply by using a fuse and the panel includes an AC socket, a DC socket, a USB socket and a charging interface.

In an exemplary embodiment, the electrical system further includes a display screen which is electrically connect to the panel circuit.

In an exemplary embodiment, the size of the solar cell packaged assembly is (300∼500mm)* (6,000∼20,000mm).

An embodiment of this application provides a portable reel-type solar power generation device which includes a roller, a moving apparatus, a rocker arm, a panel and a solar cell packaged assembly. The solar cell packaged assembly is wound on the roller in which an electrical circuit is arranged. The roller is arranged on the moving apparatus, and the rocker arm is connected with the roller for rotating the roller, assisting the winding and storage of the solar cell packaged assembly. The rocker arm can be folded and retracted. The panel is arranged at the center of the side surface of the roller. The panel is provided with input and output ports and is connected with a panel circuit.

In an exemplary embodiment, the solar cell packaged assembly includes a packaging cloth, a cable and a flexible solar cell assembly which is bonded onto a wear-resistant lining cloth. The four sides of the wear-resistant lining cloth are folded so as to enclose the flexible solar cell assembly. A fine tube accommodating hidden pocket is arranged between the wear-resistant lining cloth and the flexible solar cell assembly for arranging and connecting the cable.

In an exemplary embodiment, both ends of the packaging cloth are provided with holes for fixing and hanging. One end of the packaging cloth is provided with a handle and a snap fastener, and the other end of the packaging cloth is provided with an outlet. The cable of the assembly extends through the outlet and is connected to a circuit inside the roller.

In an exemplary embodiment, the cables are arranged along the edges of both sides of the packaging cloth. Arranging the cables along the outer edges can reduce the thickness of the reel and increase the transverse mechanical strength of the same.

In an exemplary embodiment, after the cables are led out from the flexible solar cell assembly, the cables are arranged along the accommodating hidden pockets on both sides and finally enter the interior of the roller so as to connect to a maximum power point tracking (MPPT) device. Two cables are led out from each flexible solar cell assembly, one of which is a positive cable and the other of which is a negative cable. Each flexible solar cell assembly is associated with one MPPT device.

Such design guarantees optimal independent power generation control of each assembly, even when some of the assemblies are damaged, shielded or not be deployed, and the normal assembly still can generate electricity at maximum efficiency.

In an exemplary embodiment, the diameter of the roller is not greater than 500 mm.

In an exemplary embodiment, the solar cell packaged assembly consists of an array formed by one or more (in an example, two) flexible solar cell assemblies.

In an exemplary embodiment, the size of the solar cell packaged assembly is (300~500mm)* (6,000∼20,000mm).

In an exemplary embodiment, an electrical system is arranged inside the roller, and the electrical system includes a maximum power point tracking device, a DC power supply, a charging circuit, an AC power supply (an inverter), a battery and a panel circuit.

In an exemplary embodiment, the cables are connected with the maximum power point tracking (MPPT) device after being led out from the flexible solar cell assembly. Two cables are led out from each flexible solar cell assembly, one of which is a positive cable and the other of which is a negative cable. Each flexible solar cell assembly is associated with one MPPT device. The flexible solar cell assembly is controlled so that the flexible solar cell assembly is able to generate electricity at maximum power according to the present sunlight condition, and thereafter the cables are respectively connected to the battery and/or the AC power supply after passing through the DC power supply, and finally connected to the panel circuit.

In an exemplary embodiment, each flexible solar cell assembly is assigned with one MPPT device. The flexible solar cell assembly is controlled so that the flexible solar cell assembly is able to generate electricity at maximum power according to the present sunlight condition, in an example, two flexible solar cell assemblies. The power of each MPPT device is 100-300 W, in an example, 300W;
the DC power supply converts fluctuating photovoltaic power into a stable DC power for charging the battery, driving external DC electrical appliance and supplying power to the inverter. The DC power supply is able to output direct current of various voltage levels such as 5V, 12V, 24V and the power thereof is 200∼1000W, in an example, 600W;
the AC power supply (inverter) is used to convert a direct current from the DC power supply or the battery into an alternating current of 110V or 220V, in order to supply power to external AC electrical appliance. The power of the AC power supply is 200∼1000W, in an example, 500W;
the battery which can be a gel battery, a lithium battery or the like, in an example, a lithium battery, is used for storing energy, and the stored energy is 200~1000Wh, in an example, 500Wh;
the charging circuit is used for converting alternating current so that the charging circuit is able to be used for charging the battery, and when there is no sunlight in the environment or solar power is not used for generating electricity, the charging circuit charges the battery by using an alternating current which is supplied from outside; and
the panel circuit includes a protection circuit which protects the output power supply from shorting by using a fuse and a panel which consists of an AC socket, a DC socket, a USB socket and a charging interface.

The portable reel-type solar power generation device provided in embodiments of the present application has a stable solar tape structure and is not easy to fail. The portable reel-type solar power generation device is suitable for a long-time off-grid environment and can supply power to equipment which has a high power requirement. By the arrangement of the details of the portable reel-type solar power generation device, and the optimization of the packaging method, the winding method and the electrical structure, the reel-type power generation device is suitable for supplying power to appliances which have high power requirement and guarantees a long-time stable power supply, and the maximum power can reach 500 W.

Other aspects will become apparent after reading and understanding the drawings and the detailed description.

### Brief Description of Drawings

Fig. 1 is a schematic view of a portable reel-type solar power generation device according to an embodiment of the present application.
Fig. 2 is a schematic view of the structure of a solar cell packaged assembly according to an embodiment of the present application.
Fig. 3 is a schematic view of the structure of an electrical system according to an embodiment of the present application.

### Detailed Description

The disclosure is further explained by way of examples with reference to the figures.

In an example, a portable reel-type solar power generation device includes a roller 1, a moving apparatus 2, a rocker arm 3, a panel 4 and a solar cell packaged assembly 5.

The solar cell packaged assembly 5 is wound on the roller 1 in which an electrical circuit is arranged. The roller is arranged on the moving apparatus 2. The rocker arm 3 is connected with the roller for rotating the roller, assisting the winding and storage of the solar cell packaged assembly 5. The rocker arm can be folded and retracted.

The panel 4 is arranged at the center of the side surface of the roller. The panel is provided with input and output ports and is connected with a panel circuit.

The solar cell packaged assembly 5 includes a packaging cloth 51, a cable 52 and a flexible solar cell assembly 53. The flexible solar cell assembly is bonded onto a wear-resistant lining cloth. The four sides of the wear-resistant lining cloth are folded so as to enclose and bond to the flexible solar cell assembly. A fine tube accommodating hidden pocket is arranged between the wear-resistant lining cloth and the flexible solar cell assembly for arranging and connecting the cable.

Both ends of the packaging cloth are provided with holes 54 for fixing and hanging. One end of the packaging cloth is provided with a handle and a snap fastener which includes a head 55 and a seat 56. The other end of the packaging cloth is provided with an outlet 57. The cable of the assembly extends through the outlet and is connected to the circuit inside the roller. The packaging cloth is fixed to the roller through the holes 54 on the side where the outlet 57 is located. Such fixing can be achieved by riveting or by clamping the packaging cloth between a clamping plate and the roller by means of the clamping plate.

The cables are arranged along the edges of both sides of the packaging cloth.

After the cables are led out from an outlet box 58 of the assembly, they are arranged along the accommodating hidden pockets on both sides and finally enter the interior of the roller so as to connect to a maximum power point tracking (MPPT) device. Two cables are led out from each assembly, one of which is a positive cable and the other of which is a negative cable. Each assembly is associated with one MPPT device.

The diameter of the roller is 300 mm.

The solar cell packaged assembly consists of an array formed by one or two flexible solar cell assemblies.

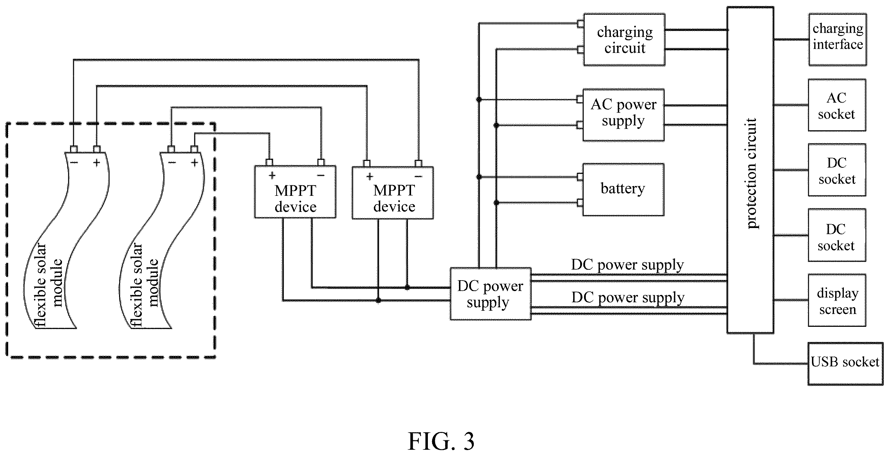

An electrical system is arranged inside the roller, and the electrical system includes a maximum power point tracking device, a DC power supply, a charging circuit, an AC power supply, a battery and a panel circuit. As shown in Fig. 3, the cables are connected with the maximum power point tracking device after being led out from the assembly. Two cables are led out from each assembly, one of which is a positive cable and the other of which is a negative cable. Each assembly is associated with one MPPT device. The assembly is controlled so that the assembly is able to generate electricity at maximum power according to the present sunlight condition. Thereafter the cables are respectively connected to the battery and/or the AC power supply after passing through the DC power supply, and finally connected to the panel circuit. An inverter is connected between the DC power supply and the AC power supply.

The power of each MPPT is 300 W.

The DC power supply converts fluctuating photovoltaic power into a stable DC power for charging the battery, driving external DC electrical appliance and supplying power to inverter. The DC power supply can output direct current of various voltage levels such as 5V, 12V, 24V, etc., and in an example, the power thereof is 600W.

The AC power supply (inverter) is used to convert direct current from the DC power supply or the battery into an alternating current of 110V or 220V by means of the inverter, in order to supply power to external AC electrical appliance. In an example, the power is 500W.

The battery which is a lithium battery is used for storing energy, and in an example, the stored energy is 500Wh.

The charging circuit is used for converting alternating current so that the charging circuit can be used for charging the battery. When there is no sunlight in the environment or solar power is not used for generating electricity, the charging circuit charges the battery by using the alternating current which is supplied from outside.

The panel circuit includes a protection circuit and a panel. The protection circuit protects the output power supply from shorting by using a fuse. The panel consists of an AC socket, a DC socket, a USB socket and a charging interface.

When in use, the portable reel-type solar power generation device is deployed and positioned in a place with sufficient sunlight in order to absorb sunlight. Since an energy storage battery is arranged in the portable reel-type solar power generation device, it is possible to stably supply power even when the sunlight is not sufficient. The portable reel-type solar power generation device is suitable for long-time outdoor use, and can supply power to electrical appliances with large power requirement. Besides, the portable reel-type solar power generation device is easy to store, and when not in use, the footprint of the device is small.

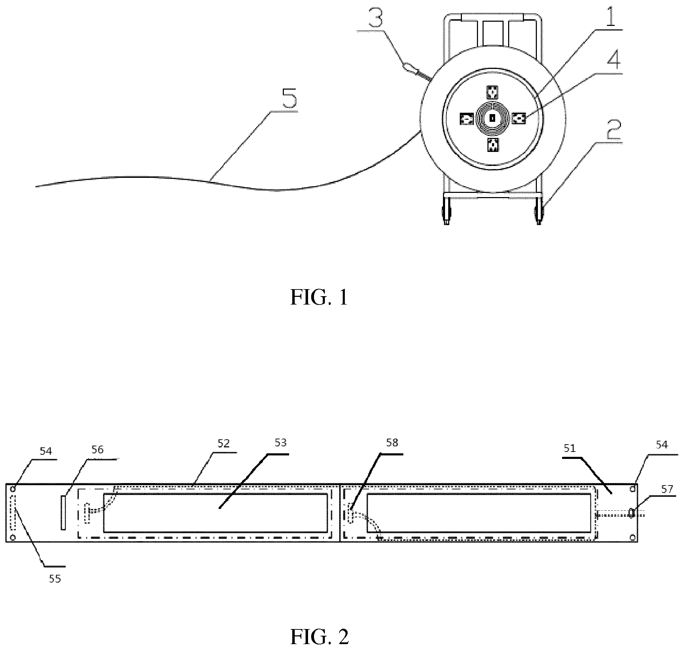

In an example, a reel-type solar power generation device, as shown in Fig. 1, includes a roller 1, a moving apparatus 2, a rocker arm 3, a panel 4 and a solar cell packaged assembly 5.

The solar cell packaged assembly 5 is wound on the roller 1 in which an electrical system is arranged. The roller 1 is arranged on the moving apparatus 2. The rocker arm 3 is configured to connect with the roller 1 for rotating the roller 1, assisting the winding and storage of the solar cell packaged assembly 5. The rocker arm 3 can be folded and retracted.

The panel 4 is arranged at the center of the side surface of the roller 1. The panel 4 is provided with input and output ports and is connected with a panel circuit.

The solar cell packaged assembly 5 includes a packaging cloth 51, a cable 52 and a flexible solar cell assembly 53. The flexible solar cell assembly 53 is bonded onto the packaging cloth 51. The four sides of the packaging cloth 51 are folded so as to enclose and bond to the flexible solar cell assembly 53. A fine tube accommodating hidden pocket is arranged between the packaging cloth 51 and the flexible solar cell assembly 53 for arranging and electrically connecting the cable. The packaging cloth 51 can be wear-resistant lining cloth.

The cable is configured to electrically connect with the flexible solar cell packaged assembly. The four sides of the packaging cloth 51 are folded and bonded onto the flexible solar cell assembly 53 so as to enclose the same. The cable is positioned in the fine tube accommodating hidden pocket.

Both ends of the packaging cloth 51 are provided with holes 54 for fixing and hanging. One end of the packaging cloth 51 is provided with a handle and a snap fastener which includes a head 55 and a seat 56. The other end of the packaging cloth is provided with an outlet 57. The cable of the flexible solar cell assembly 53 extends through the outlet 57 and is connected to the electrical system inside the roller 1. The packaging cloth 51 is fixed to the roller 1 through the holes 54 on the side where the outlet 57 is located. Such fixing can be achieved by riveting or by clamping the packaging cloth between a clamping plate and the roller by means of the clamping plate.

The handle is arranged on the end of the packaging cloth 51 away from the outlet 57. The handle can be positioned on the extended end of the solar cell packaged assembly 5 of Fig. 1.

The fine tube accommodating hidden pockets are positioned beside both sides of the flexible solar cell assembly 53 at the edges of both sides of the packaging cloth 51. The cables 52 are arranged along the edges of both sides of the packaging cloth 51.

Arranging the cables 52 along the edges of both sides can reduce the thickness of the reel and increase the transverse mechanical strength of the same.

As shown in Fig. 2, after the cables 52 are led out from an outlet box 58 of the flexible solar cell assembly 53, they are arranged along the fine tube accommodating hidden pockets on both sides and finally enter the interior of the roller 1 so as to connect to a maximum power point tracking (MPPT) device. Two cables are led out from each flexible solar cell assembly 53, one of which is a positive cable and the other of which is a negative cable. Each flexible solar cell assembly 53 is associated with one MPPT device.

Such design guarantees optimal independent power generation control of each assembly, even when some of the assemblies are damaged, shaded or not be pulled out, and the normal assembly still can generate electricity at maximum efficiency.

The diameter of the roller 1 is not greater than 500mm, and can be designed to 300 mm.

As shown in Figs. 2 and 3, the solar cell packaged assembly includes two flexible solar cell assemblies 53 (i.e., the two flexible solar cell assemblies in Fig. 3) which form an array.

As shown in Fig. 3, an electrical system is arranged inside the roller 1, and the electrical system includes a maximum power point tracking device, a DC power supply, a charging circuit, an AC power supply, a battery and a panel circuit. As shown in Fig. 3, the cables are connected with the maximum power point tracking device after being led out from the flexible solar cell assembly 53. Two cables are led out from each flexible solar cell assembly 53, one of which is a positive cable and the other of which is a negative cable. Each flexible solar cell assembly 53 is associated with one MPPT device. The flexible solar cell assembly 53 generates electricity at maximum power according to the present sunlight condition. Thereafter the cables are connected to one or both of the battery and the AC power supply after passing through the DC power supply, and finally connected to the panel circuit. An inverter may be connected between the DC power supply and the AC power supply.

The maximum power point tracking device is configured to connect with the charging circuit, the AC power supply and the battery through the DC power supply. The DC power supply, the AC power supply and the charging circuit are also configured to connect to the panel circuit. The DC power supply is configured to connect to one or both of the battery and the AC power supply and connect to the panel circuit.

The power of each MPPT device can range from 100W to 300W, and can be set to 300W. The DC power supply converts fluctuating photovoltaic power into a stable DC power and is configured for charging the battery, driving external DC electrical appliance and supplying power to inverter. The DC power supply can output direct current of various voltage levels such as 5V, 12V, 24V. The power of the DC power supply can range from 200W to 1000W, and can be set to 600W.

The AC power supply (on which an inverter is provided) is configured to convert direct current from the DC power supply or the battery into an alternating current of 110V or 220V by means of the inverter, in order to supply power to external AC electrical appliance. The power of the AC power supply can range from 200W to 1000W, and can be set to 500W.

The battery which is a lithium battery or a gel battery is used for storing energy, and the stored energy can range from 200Wh to 1000Wh, and can be set to 500Wh.

The charging circuit is configured to charge the battery by using the alternating current which is supplied from outside when there is no sunlight in the environment or solar power is not used for generating electricity.

The panel circuit includes a protection circuit which protects the output power supply from shorting by using a fuse. The panel includes an AC socket, a DC socket, a USB socket and a charging interface. The panel is electrically connected to the protection circuit.

The panel includes an AC socket, a DC socket, a USB socket and a charging interface. Input and output ports are arranged on the panel. The input and output ports include an input port and an output port.

In an exemplary embodiment, the input and output ports are positioned on the AC socket, the DC socket, the USB socket and the charging interface. The jacks of the AC socket, the DC socket and the USB socket are the output ports, and the jack of the charging interface is the input port.

A display screen is also arranged on the panel. The display screen is electrically connect to the protect circuit, and used for display the information about the amount of electricity, the electric current and the time. The USB socket is used for charging a mobile phone, a charge pal and the like.

As shown in Fig. 3, a flexible solar assembly is a flexible solar cell assembly.

When in use, the portable reel-type solar power generation device is deployed and positioned in a place with sufficient sunlight in order to absorb sunlight. Since a battery is arranged in the portable reel-type solar power generation device, it is possible to stably supply power even when the sunlight is not sufficient. The portable reel-type solar power generation device is suitable for long-time outdoor use, and can supply power to electrical appliances with large power requirement. Besides, the portable reel-type solar power generation device is easy to store, and when not in use, the footprint of the device is small.

The above embodiments are only for providing detailed description of this application, and in no way limit the protection scope of thereof which is defined by the claims. According to the known technology in the art and the technical scheme disclosed herein, many variant schemes can be deduced or conceived. All of these variant schemes should also be considered as falling within the protection scope of this disclosure.

## Claims

1. A reel-type solar power generation device, comprising a roller (1), a moving apparatus (2) and a solar cell packaged assembly (5); wherein the solar cell packaged assembly (5) is configured to be wound on the roller (1) which is arranged on the moving apparatus (2).

2. The reel-type solar power generation device of claim 1, further comprising:
a panel (4) arranged on the roller (1) in which an electrical system is arranged.

3. The reel-type solar power generation device of claim 2, further comprising:
a rocker arm (3) which is able to be folded and retracted and is configured to be connected with the roller (1), wherein the panel (4) is arranged at the center of a side surface of the roller (1) and configured to electrically connect with a panel circuit and provided with input and output ports.

4. The reel-type solar power generation device of any one of claims 1-3, wherein the solar cell packaged assembly (5) comprises a packaging cloth (51), a cable (52) and a flexible solar cell assembly (53) which is configured to be bonded onto the packaging cloth (51), and wherein the cable (52) is configured to be electrically connected to the flexible solar cell assembly (53).

5. The reel-type solar power generation device of claim 4, wherein the four sides of the packaging cloth (51) are folded and bonded to the flexible solar cell assembly (53) so as to enclose the flexible solar cell assembly (53), and wherein a fine tube accommodating hidden pocket is arranged between the packaging cloth (51) and the flexible solar cell assembly (53) for arranging the cable (52).

6. The reel-type solar power generation device of claim 4, wherein both ends of the packaging cloth (51) are provided with holes (54), wherein one end of the packaging cloth (51) is provided with a handle and a snap fastener and the other end of the packaging cloth (51) is provided with an outlet (57), and wherein the cable (52) extends through the outlet (57) and is connected to the electrical system.

7. The reel-type solar power generation device of claim 5, wherein the fine tube accommodating hidden pockets are positioned at the edges of both sides of the packaging cloth (51).

8. The reel-type solar power generation device of claim 4, wherein the cables (52) are configured to be electrically connected with the maximum power point tracking device, wherein two cables are led out from each flexible solar cell assembly (53), one of which is a positive cable and the other of which is a negative cable, and wherein each flexible solar cell assembly (53) is associated with one maximum power point tracking device.

9. The reel-type solar power generation device of claim 1, wherein the diameter of the roller (1) is not greater than 500mm.

10. The reel-type solar power generation device of claim 4, wherein the solar cell packaged assembly (5) comprises one or more flexible solar cell assemblies (53).

11. The reel-type solar power generation device of claim 2 or 3, wherein the electrical system comprises a maximum power point tracking device, a DC power supply, a charging circuit, an AC power supply, a battery and a panel circuit, wherein the maximum power point tracking device is configured to electrically connect with the charging circuit, the AC power supply and the battery through the DC power supply, and wherein the DC power supply, the AC power supply and the charging circuit are configured to connect to the panel circuit.

12. The reel-type solar power generation device of claim 11, wherein an inverter is connected between the DC power supply and the AC power supply or arranged on the AC power supply.

13. The reel-type solar power generation device of claim 11, wherein the power of each maximum power point tracking device is 100-300 W;
wherein the DC power supply converts fluctuating photovoltaic power into a stable DC power for charging the battery, driving external DC electrical appliance and supplying power to the inverter, wherein the output voltage of the DC power supply comprises one or more of 5V, 12V, 24V and the power of the DC power supply is 200∼1000W;
wherein the AC power supply which is connected with an inverter is used to convert a direct current from the DC power supply or the battery into an alternating current of 110V or 220V by means of the inverter, in order to supply power to external AC electrical appliance, wherein the power of the AC power supply is 200∼1000W;
wherein the battery is configured for storing energy, and the stored energy is 200~1000Wh; wherein the charging circuit charges the battery by using an alternating current which is supplied from outside when there is no sunlight in the environment or solar power is not used for generating electricity; and
wherein the panel circuit comprises a protection circuit which protects the output power supply by using a fuse and the panel consists of an AC socket, a DC socket, a USB socket and a charging interface.

14. The reel-type solar power generation device of claim 11, wherein the electrical system further comprises a display screen which is electrically connect to the panel circuit.
